# EUROPEAN PATENT APPLICATION

(11) **EP 4 730 944 A1**
(43) Date of publication of application: **22.04.2026**
(21) Application number: 25206837.4
(22) Date of filing: 06.10.2025
(51) Int. Cl.: H10B 12/00, H10D 30/67

(54) **SEMICONDUCTOR DEVICE**

(30) Priority: 16.10.2024 KR 20240141452
(71) Applicant: Samsung Electronics Co., Ltd., Suwon-si, Gyeonggi-do 16677 (KR)
(72) Inventor: AHN, Dongho, 16677 Suwon-si, Gyeonggi-do (KR); OH, Sechung, 16677 Suwon-si, Gyeonggi-do (KR); YOON, Minseo, 16677 Suwon-si, Gyeonggi-do (KR); LEE, Jinwoo, 16677 Suwon-si, Gyeonggi-do (KR); CHOI, Jinmyung, 16677 Suwon-si, Gyeonggi-do (KR); HORII, Hideki, 16677 Suwon-si, Gyeonggi-do (KR)
(74) Representative: Kuhnen & Wacker Patent- und Rechtsanwaltsbüro PartG mbB

(57) **Abstract**

A semiconductor device (100) is provided. The semiconductor device (100) includes: a bit line (BL) provided on a substrate (110) and extending along a first horizontal direction (Y); a mold structure (130) provided on the bit line (BL), extending along a second horizontal direction (X) crossing the first horizontal direction (Y), and including a metal layer (134); an active semiconductor layer (AP) extending along a vertical direction (Z) on a side wall of the mold structure (130) and including an oxide semiconductor; and a word line (WL) provided on a side wall of the active semiconductor layer (AP) and extending along the second horizontal direction (X). At least a portion of the side wall of the active semiconductor layer (AP) is in contact with the metal layer (134).

## Description

### BACKGROUND

The present disclosure relates to a semiconductor device, and more specifically, to a semiconductor device including a vertical channel transistor.

With the downscaling of semiconductor devices, the size of dynamic random-access memory (DRAM) devices has also been decreased. In a DRAM device having a 1T-1C structure in which one capacitor is connected to one transistor, leakage current through a channel region may become increasingly larger as the device becomes smaller. To reduce leakage current, a vertical channel transistor using an oxide semiconductor material as a channel layer has been proposed.

### SUMMARY

One or more example embodiments provide a semiconductor device with excellent electrical performance.

According to an aspect of an example embodiment, a semiconductor device includes: a bit line provided on a substrate and extending along a first horizontal direction; a mold structure provided on the bit line, extending along a second horizontal direction crossing the first horizontal direction, and including a metal layer; an active semiconductor layer extending along a vertical direction on a side wall of the mold structure and including an oxide semiconductor; and a word line provided on a side wall of the active semiconductor layer and extending along the second horizontal direction. At least a portion of the side wall of the active semiconductor layer is in contact with the metal layer.

According to another aspect of an example embodiment, a semiconductor device includes: a bit line provided on a substrate and extending along a first horizontal direction; a mold structure provided on the bit line, extending along a second horizontal direction crossing the first horizontal direction, and including a first insulating layer, a metal layer, and a second insulating layer, which are stacked in a vertical direction; an active semiconductor layer extending along the vertical direction on a side wall of the mold structure, including an oxide semiconductor, and being in contact with a side wall of the metal layer; a word line provided on a side wall of the active semiconductor layer and extending along the second horizontal direction; and a cell capacitor provided on the active semiconductor layer.

According to another aspect of an example embodiment, a semiconductor device includes: a peripheral circuit region provided on a substrate; a plurality of bit lines provided on the peripheral circuit region and extending along a first horizontal direction; a plurality of mold structures provided on the plurality of bit lines, and extending along a second horizontal direction crossing the first horizontal direction, wherein a first mold structure of the plurality of mold structures includes a first insulating layer, a metal layer, and a second insulating layer, which are stacked in a vertical direction; a plurality of active semiconductor layers, wherein a first active semiconductor layer of the plurality of active semiconductor layers is provided between the first mold structure and a second mold structure among the plurality of mold structures, on side walls of the first and second mold structures, and on a top surface of each of the plurality of bit lines, and has a U-shaped vertical cross-section; a first word line and a second word line, which are provided between the first and second mold structures, extend along the second horizontal direction, and are spaced apart from each other; and a plurality of cell capacitors provided on the plurality of active semiconductor layers. At least a portion of each of the plurality of active semiconductor layers is in contact with the metal layer.

### BRIEF DESCRIPTION OF DRAWINGS

The above and other aspects and features will be more apparent from the following description of example embodiments, taken in conjunction with the accompanying drawings, in which:
FIG. 1 is a schematic view showing a semiconductor device according to some example embodiments;
FIG. 2 is an enlarged layout diagram of a cell array region of FIG. 1 according to some example embodiments;
FIG. 3 is a cross-sectional view taken along a line A1-A1' of FIG. 2 according to some example embodiments;
FIG. 4 is a cross-sectional view taken along a line A2-A2' of FIG. 2 according to some example embodiments;
FIG. 5 is an enlarged view of a portion CX1 of FIG. 3 according to some example embodiments;
FIG. 6 shows a schematic graph of oxygen content along a line S1-S2 of FIG. 5 according to some example embodiments;
FIG. 7 is a cross-sectional view showing a semiconductor device according to some example embodiments;
FIGS. 8 and 9 are cross-sectional views showing a semiconductor device according to some example embodiments; and
FIGS. 10A, 10B, 10C, 11A, 11B, 11C, 12A, 12B, 13A, 13B, 13C, 14A, 14B, 15A, 15B, 15C, 16A, 16B, 17A, 17B, 18A, 18B, 19A, and 19B are schematic views showing a method of manufacturing a semiconductor device according to some example embodiments.

### DETAILED DESCRIPTION

Hereinafter, example embodiments will be described in detail with reference to the accompanying drawings. Embodiments described herein are example embodiments, and thus, the present disclosure is not limited thereto, and may be realized in various other forms. Each example embodiment provided in the following description is not excluded from being associated with one or more features of another example or another example embodiment also provided herein or not provided herein but consistent with the present disclosure. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. It will be also understood that, even if a certain step or operation of manufacturing an apparatus or structure is described later than another step or operation, the step or operation may be performed later than the other step or operation unless the other step or operation is described as being performed after the step or operation.

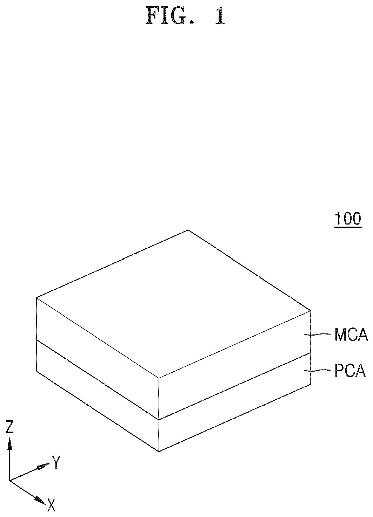

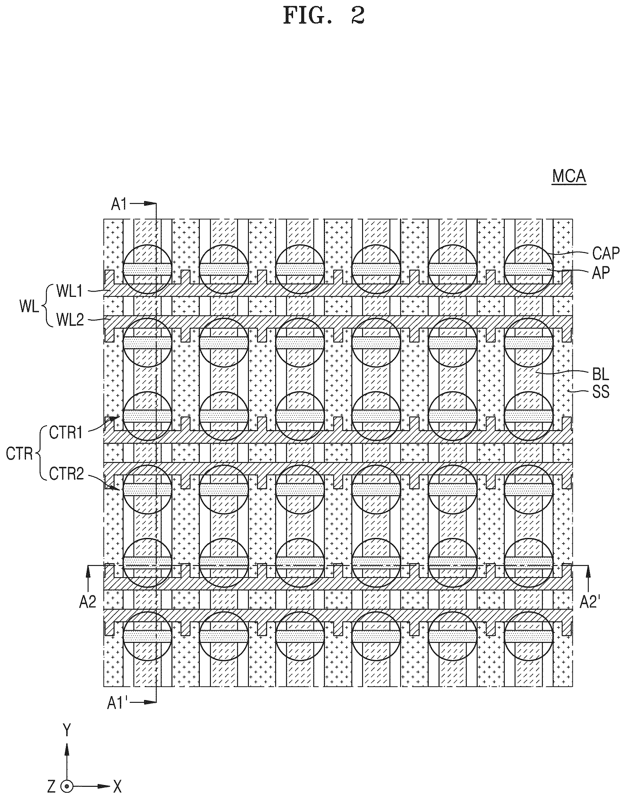

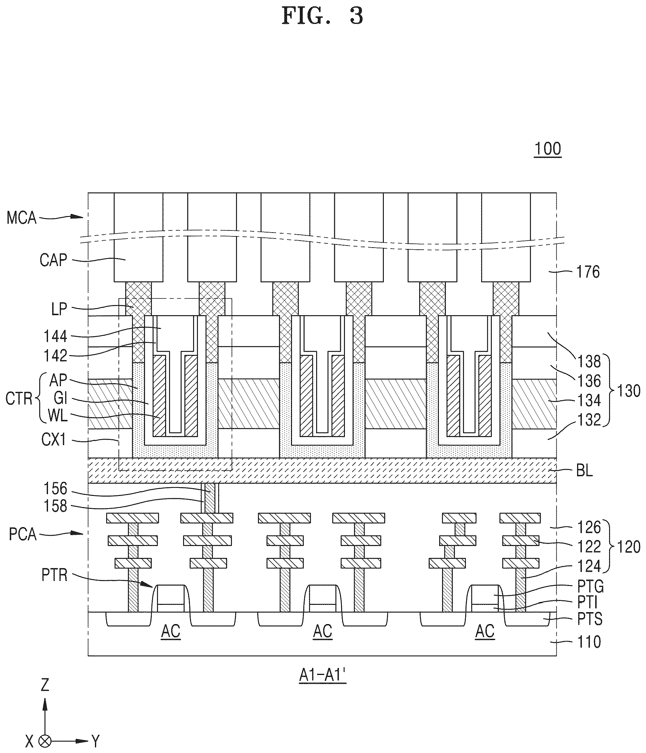

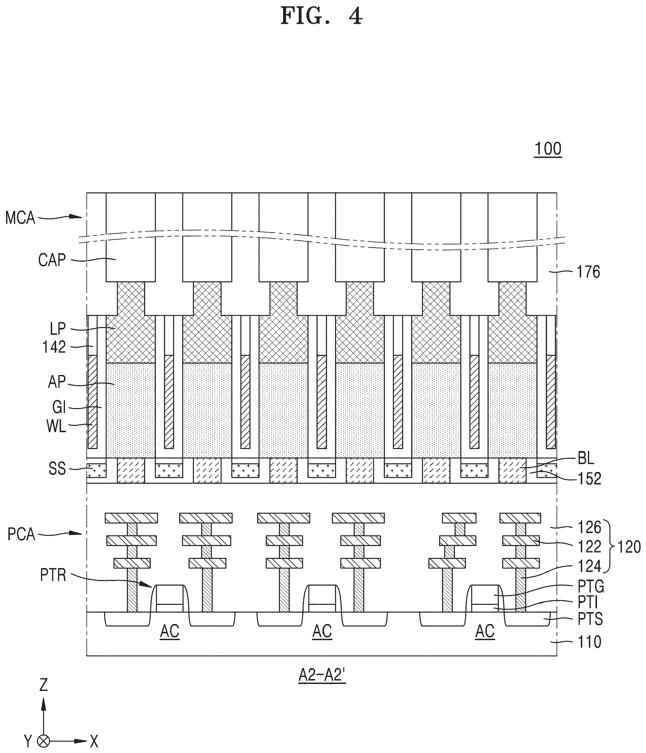

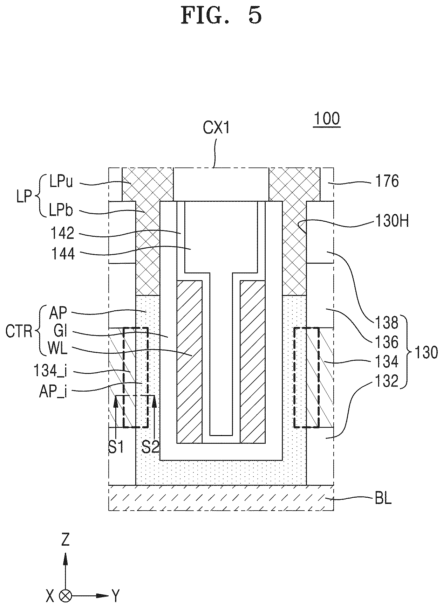

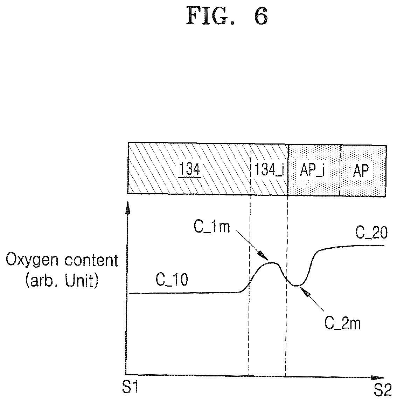

FIG. 1 is a schematic view showing a semiconductor device 100 according to some example embodiments. FIG. 2 is an enlarged layout diagram of a cell array region MCA of FIG. 1. FIG. 3 is a cross-sectional view taken along a line A1-A1' of FIG. 2. FIG. 4 is a cross-sectional view taken along a line A2-A2' of FIG. 2. FIG. 5 is an enlarged view of a portion CX1 of FIG. 3. FIG. 6 shows a schematic graph of oxygen content along a line S1-S2 of FIG. 5.

Referring to FIGS. 1 to 6, the semiconductor device 100 may include a peripheral circuit region PCA and the cell array region MCA arranged at a vertical level higher than the peripheral circuit region PCA.

In some example embodiments, the cell array region MCA may be a memory cell region of a dynamic random-access memory (DRAM) device, and the peripheral circuit region PCA may be a core region or a peripheral circuit region of a DRAM device. For example, the peripheral circuit region PCA may include a peripheral circuit transistor PTR for transmitting a signal and/or power to the memory cell array included in the cell array region MCA. In some example embodiments, the peripheral circuit transistor PTR may include various circuits such as a command decoder, control logic, an address buffer, a row decoder, a column decoder, a sense amplifier, and a data input/output circuit.

As shown in FIG. 2, a plurality of word lines WL extending in a first horizontal direction X and a plurality of bit lines BL extending in a second horizontal direction Y may be arranged in the cell array region MCA. A plurality of cell transistors CTR may be arranged at intersecting points of the plurality of word lines WL and the plurality of bit lines BL. A plurality of cell capacitors CAP may be respectively arranged on the plurality of cell transistors CTR.

The plurality of word lines WL may include a first word line WL1 and a second word line WL2, which are alternately arranged in the second horizontal direction Y, and the plurality of cell transistors CTR may include a first cell transistor CTR1 and a second cell transistor CTR2, which are alternately arranged in the second horizontal direction Y. The first cell transistor CTR1 may be arranged adjacent to the first word line WL1, and the second cell transistor CTR2 may be arranged adjacent to the second word line WL2. The first cell transistor CTR1 and the second cell transistor CTR2 may be mirror symmetrical to each other. For example, the first cell transistor CTR1 and the second cell transistor CTR2 may be mirror symmetrical about a central line extending in the first horizontal direction X and arranged between the first cell transistor CTR1 and the second cell transistor CTR2.

In some example embodiments, a pitch of the plurality of bit lines BL (for example, the sum of a width of one bit line BL and a distance between two adjacent bit lines BL) may be 2F, a pitch of the first word line WL1 may be 2F (or a pitch of the second word line WL2 may be 2F), and a unit area for forming one cell transistor CTR may be 4F² (F being a positive number). Therefore, the cell transistor CTR may have a crosspoint type that requires a relatively small unit area, which may be advantageous for improving the integration density of the semiconductor device 100.

An edge region may be arranged around the cell array region MCA. The edge region may be where an electrical connection member for a word line WL and/or an electrical connection member for a bit line BL are arranged, or may be where an electrical connection member that enables electrical connection between the cell array region MCA and the peripheral circuit region PCA is arranged.

Hereinafter, as shown in FIGS. 3 and 4, a case where the cell array region MCA is arranged at a vertical level higher than the peripheral circuit region PCA (for example, a case where the cell array region MCA is arranged on the peripheral circuit region PCA) is described. However, the semiconductor device 100 may be arranged upside down so that the cell array region MCA is arranged at a vertical level higher than the peripheral circuit region PCA, and in this case, in the following description, it should be understood that the "top surface" or "bottom surface" of components respectively refers to the "bottom surface" or "top surface" of the components, it should be understood that components arranged "above" or "under" a component are respectively arranged "under" or "above the component, and it should be understood that a component "arranged at a higher vertical level" is "arranged at a lower vertical level".

A substrate 110 may include silicon, for example, single crystalline silicon, polycrystalline silicon, or amorphous silicon. In some example embodiments, the substrate 110 may include at least one selected from Ge, SiGe, SiC, GaAs, InAs, and InP. In some example embodiments, the substrate 110 may include a conductive region, for example, a well doped with impurities, or a structure doped with impurities.

In the peripheral circuit region PCA, an active region AC may be defined on the substrate 110, and the peripheral circuit transistor PTR may be arranged on the active region AC of the substrate 110. The peripheral circuit transistor PTR may include a gate electrode PTG, a gate insulating layer PTI, and a source/drain region PTS.

A peripheral circuit wiring structure 120 covering the peripheral circuit transistor PTR may be arranged on the substrate 110. The peripheral circuit wiring structure 120 may include a peripheral circuit wiring 122, a peripheral circuit contact 124, and a peripheral circuit insulating layer 126. The peripheral circuit wiring 122 and the peripheral circuit contact 124 may be electrically connected to the peripheral circuit transistor PTR and/or the substrate 110, and the peripheral circuit insulating layer 126 may cover the peripheral circuit transistor PTR, the peripheral circuit wiring 122, and the peripheral circuit contact 124 on the substrate 110. The peripheral circuit insulating layer 126 may include an oxide film, a nitride film, a low-κ dielectric film (i.e., a dielectric film having a dielectric constant less than that of silicon oxide), or a combination thereof, and may be formed to have a stacked structure of a plurality of insulating layers.

A plurality of bit lines BL may be arranged on the peripheral circuit region PCA, a cell transistor CTR may be arranged on the plurality of bit lines BL, and a cell capacitor CAP may be arranged on the cell transistor CTR.

In some example embodiments, the plurality of bit lines BL may extend in the second horizontal direction Y, and a bit line insulating layer 152 and a shield metal layer SS may be arranged in a space between the plurality of bit lines BL. In some example embodiments, the shield metal layer SS may be arranged between two adjacent bit lines BL, and a top surface, a bottom surface, and a side wall of the shield metal layer SS may be covered by the bit line insulating layer 152.

In some example embodiments, a bit line BL may include Ti, TiN, Ta, TaN, Mo, Ru, W, WN, Co, Ni, TiSi, TiSiN, WSi, WSiN, TaSi, TaSiN, RuTiN, CoSi, NiSi, polysilicon, or a combination thereof. In some example embodiments, the shield metal layer SS may include Ti, TiN, Ta, TaN, Mo, Ru, W, WN, Co, Ni, Cu, Al, TiSi, TiSiN, WSi, WSiN, TaSi, TaSiN, RuTiN, CoSi, NiSi, or a combination thereof.

A bit line contact 156 may be arranged between a bottom surface of the bit line BL and the peripheral circuit wiring 122, and a side wall of the bit line contact 156 may be surrounded by a bit line contact spacer 158. In some example embodiments, the bit line contact spacer 158 may be omitted.

A plurality of mold structures 130 and a plurality of cell transistors CTR may be arranged on a top surface of the bit line BL. For example, each of the plurality of mold structures 130 may extend in the first horizontal direction X, and the plurality of cell transistors CTR may be arranged on both side walls of respective mold structures 130.

Each of the plurality of mold structures 130 may include a first insulating layer 132, a metal layer 134, a second insulating layer 136, and a capping layer 138, which are arranged in a vertical direction Z. In some example embodiments, the first insulating layer 132 and the second insulating layer 136 may include at least one of silicon oxide, silicon nitride, silicon oxynitride, and a low-k dielectric material. In some example embodiments, the capping layer 138 may include at least one of silicon oxide, silicon nitride, and silicon oxynitride.

In some example embodiments, the metal layer 134 may include at least one of aluminum, titanium, tungsten, copper, molybdenum, ruthenium, tantalum, and cobalt. In some example embodiments, the metal layer 134 may further include at least one of titanium nitride, tungsten nitride, molybdenum nitride, ruthenium nitride, tantalum nitride, and cobalt nitride.

In some example embodiments, the cell transistor CTR may include an active semiconductor layer AP, a gate insulating layer GI, and a word line WL, which are sequentially arranged on a side wall of a mold structure 130.

In some example embodiments, the active semiconductor layer AP may include a portion extending in the vertical direction Z on the side wall of the mold structure 130, and a portion extending in the second horizontal direction Y on the top surface of the bit line BL. In some example embodiments, the active semiconductor layer AP may have a U-shaped vertical cross-section.

In some example embodiments, the active semiconductor layer AP may include at least one of zinc tin oxide (ZnₓSn_{y}O), indium zinc oxide (InₓZn_{y}O), zinc oxide (ZnOₓ), indium gallium zinc oxide (InₓGa_{y}Zn_{z}O), indium gallium silicon oxide (InₓGa_{y}Si_{z}O), indium tungsten oxide (InₓW_{y}O), indium oxide (InₓO), tin oxide (SnₓO), titanium oxide (TiₓO), zinc oxynitride (ZnₓON_{z}), magnesium zinc oxide (MgₓZn_{y}O), zirconium indium zinc oxide (ZrₓIn_{y}Zn_{z}O), hafnium indium zinc oxide (HfₓIn_{y}Zn_{z}O), tin indium zinc oxide (SnₓIn_{y}Zn_{z}O), aluminum tin indium zinc oxide (AlₓSn_{y}In_{z}ZnₐO), silicon indium zinc oxide (SiₓIn_{y}Zn_{z}O), aluminum zinc tin oxide (AlₓZn_{y}Sn_{z}O), gallium zinc tin oxide (GaₓZn_{y}Sn_{z}O), and zirconium zinc tin oxide (ZrₓZn_{y}Sn_{z}O). In some example embodiments, the active semiconductor layer AP may further include n-type impurity ions. For example, the n-type impurity ions may be doped into the active semiconductor layer AP through an ion implantation process, etc.

As shown in FIG. 5, at least a portion of a side wall of the active semiconductor layer AP may be in contact with a side wall of the metal layer 134 of the mold structure 130. For example, the side wall of the active semiconductor layer AP may be in contact with a side wall of the first insulating layer 132, the side wall of the metal layer 134, and a side wall of the second insulating layer 136. A portion of the active semiconductor layer AP, which is in contact with the side wall of the metal layer 134, may be referred to as a conductive region AP_i. In some example embodiments, the conductive region AP_i may have a lower oxygen content than other regions of the active semiconductor layer AP (for example, a bulk region of the active semiconductor layer AP).

As shown in FIG. 5, a portion of the metal layer 134, which is adjacent to the conductive region AP_i of the active semiconductor layer AP, may be where oxygen atoms have moved or diffused from the conductive region AP_i of the active semiconductor layer AP. The portion of the metal layer 134, which is adjacent to the conductive region AP_i of the active semiconductor layer AP, may be referred to as an insulating region 134_i.

As schematically shown in FIG. 6, a bulk region of the metal layer 134 may have a first oxygen content C_10, and the first oxygen content C_10 may be substantially 0. When the first oxygen content C_10 is substantially 0, it may mean that the bulk region of the metal layer 134 may have an oxygen content within a range of the content of oxygen that has inevitably penetrated into the metal layer 134 during a manufacturing process, or within a range of the content of oxygen that may naturally exist in the metal layer 134, and it may mean that oxygen atoms may not have intentionally implanted or added into the metal layer 134.

As schematically shown in FIG. 6, the insulating region 134_i of the metal layer 134 may have a second oxygen content C_1m greater than the first oxygen content C_10. In some example embodiments, the second oxygen content C_1m may be greater than 0 at% and less than or equal to 50 at%. In some example embodiments, the second oxygen content C_1m may be greater than 0 at% and less than or equal to 30 at%, and in some example embodiments, the second oxygen content C_1m may be greater than 0 at% and less than or equal to 20 at%.

In some example embodiments, the metal layer 134 includes a first metal, and when the first metal has a formula represented by M, at least a portion of the insulating region 134_i of the metal layer 134 may be represented by a formula of MOₓ (0 < x ≤ 0.5).

The second oxygen content C_1m of the insulating region 134_i may vary depending on selection of the type of material of the metal layer 134 and the type of material of the active semiconductor layer AP, and for example, may vary depending on a relative magnitude difference between the oxygen bonding strength of the metal layer 134 and the oxygen bonding strength of the active semiconductor layer AP.

In some example embodiments, the bulk region of the active semiconductor layer AP may have a third oxygen content C_20, and the conductive region AP_i of the active semiconductor layer AP may have a fourth oxygen content C_2m that is less than the third oxygen content C_20.

In some example embodiment, the metal layer 134 included in the mold structure 130 may function as a scavenging region that takes oxygen atoms from the active semiconductor layer AP, and oxygen atoms may move or diffuse into the metal layer 134 from a partial region of the active semiconductor layer AP, which is adjacent to a contact interface between the active semiconductor layer AP and the metal layer 134, and accordingly, the conductive region AP_i of the active semiconductor layer AP and the insulating region 134_i of the metal layer 134 may be arranged adjacent to each other.

In some example embodiments, a top surface of the metal layer 134 may be arranged at a vertical lower level than a top surface of the active semiconductor layer AP. In some example embodiments, the top surface of the metal layer 134, a top surface of the insulating region 134_i, and a top surface of the conductive region AP_i may be arranged at the same vertical level. For example, the top surface of the conductive region AP_i may be spaced apart from the top surface of the active semiconductor layer AP in the vertical direction Z.

In some example embodiments, a bottom surface of the metal layer 134 may be arranged at a vertical level higher than a bottom surface of the active semiconductor layer AP. In some example embodiments, the bottom surface of the metal layer 134, a bottom surface of the insulating region 134_i, and a bottom surface of the conductive region AP_i may be arranged at the same vertical level. For example, the bottom surface of the conductive region AP_i may be spaced apart from the bottom surface of the active semiconductor layer AP in the vertical direction Z.

The gate insulating layer GI may be arranged on a side wall of the active semiconductor layer AP. In some example embodiments, the gate insulating layer GI may include at least one selected from a high-κ dielectric material having a higher dielectric constant than silicon oxide and a ferroelectric material. In some example embodiments, the gate insulating layer GI may include at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PbZrTiO), strontium bismuth tantalum oxide (SrBiTaO), bismuth iron oxide (BiFeO), strontium titanium oxide (SrTiO), yttrium oxide (YO), aluminum oxide (AlO), and lead scandium tantalum oxide (PbScTaO).

The word line WL may be arranged on a side wall of the gate insulating layer GI. In some example embodiments, the word line WL may include Ti, TiN, Ta, TaN, Mo, Ru, W, WN, TiSiN, WSiN, polysilicon, or a combination thereof. For example, two word lines WL may be spaced apart from each other between two adjacent mold structures 130 and extend in the first horizontal direction X. For example, the first word line WL1 and the second word line WL2 may be arranged apart from each other between two adjacent mold structures 130. The word line WL may have a rectangular vertical cross-section.

An insulating liner 142 and a buried insulating layer 144 may be arranged between the first word line WL1 and the second word line WL2. The insulating liner 142 may be conformally arranged on side walls and top surfaces of the first word line WL1 and the second word line WL2, and may be arranged between the word line WL and the buried insulating layer 144.

A plurality of landing pads LP may be arranged on the plurality of cell transistors CTR, and the cell capacitor CAP may be arranged on the plurality of landing pads LP. The plurality of landing pads LP may include Ti, TiN, Ta, TaN, W, WN, TiSiN, WSiN, polysilicon, or a combination thereof. As shown in FIG. 5, each of the plurality of landing pads LP may include: a lower portion LPb arranged at a lateral side of the mold structure 130 and above the active semiconductor layer AP; and an upper portion LPu arranged at a vertical level higher than the mold structure 130 and the top surface of the active semiconductor layer AP and connected to the lower portion LPb.

The cell capacitor CAP may have a metal-insulator-metal type capacitor structure. For example, the cell capacitor CAP may include a first electrode, a second electrode, and a capacitor dielectric layer arranged between the first electrode and the second electrode. An insulating layer 176 may be arranged on a top surface of a landing pad LP and at least a portion of the cell capacitor CAP.

In a semiconductor device including an oxide semiconductor channel according to a comparative example, a mold structure includes an insulating material, and an active semiconductor layer is arranged on a side wall of the mold structure. Because there is a relatively high-density trap site within the active semiconductor layer, on-current of a cell transistor is relatively low.

In contrast, according to some example embodiments, the mold structure 130 may include the metal layer 134, and the conductive region AP_i may be formed in the portion of the active semiconductor layer AP, which is in contact with the side wall of the metal layer 134. The conductive region AP_i may include a relatively large amount of free electrons, these free electrons may occupy a trap site within the active semiconductor layer AP, and the active semiconductor layer AP may have a reduced trap density compared to the comparative example. Therefore, the semiconductor device 100 may have a relatively high on-current and excellent electrical performance.

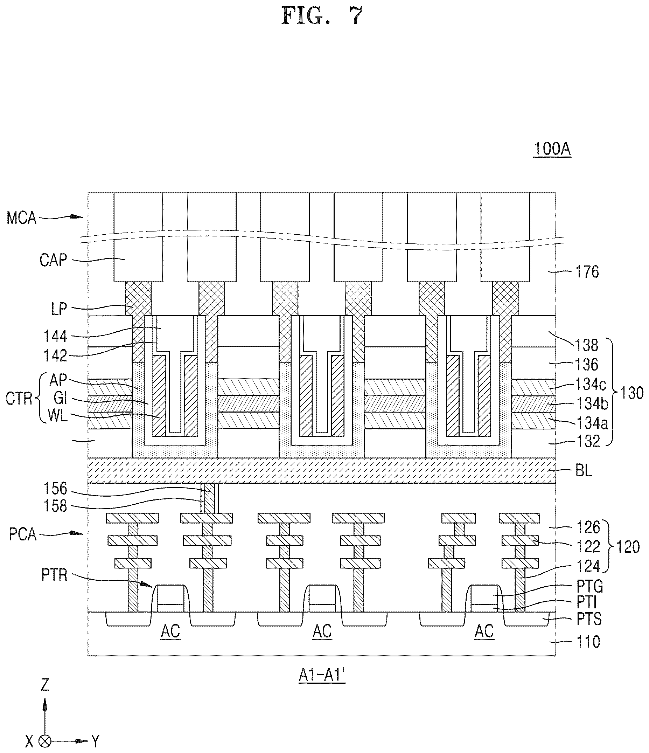

FIG. 7 is a cross-sectional view showing a semiconductor device 100A according to some example embodiments.

Referring to FIG. 7, the mold structure 130 may include the first insulating layer 132, a first metal layer 134a, a second metal layer 134b, a third metal layer 134c, the second insulating layer 136, and the capping layer 138. In some example embodiments, the first metal layer 134a and the third metal layer 134c may include the same metal material, for example, a first metal, and the second metal layer 134b may include a different metal material than the first metal layer 134a and the third metal layer 134c, for example, a second metal. In some example embodiments, the first metal layer 134a may include a first metal, the second metal layer 134b may include a second metal that is different from the first metal, and the third metal layer 134c may include a third metal that is different from the first metal and the second metal.

The constituent materials and thickness of the first metal layer 134a, the second metal layer 134b, and the third metal layer 134c may vary depending on a required profile of oxygen content of the conductive region AP_i (see FIG. 5) included in the active semiconductor layer AP.

In some example embodiments, the first metal layer 134a and the third metal layer 134c may include a first metal, and the second metal layer 134b may include a second metal. The first metal may include a material with greater oxygen bonding strength than the second metal. Accordingly, the oxygen content of a conductive region of the active semiconductor layer AP, which is adjacent to the second metal layer 134b, may be lower than the oxygen content of a conductive region of the active semiconductor layer AP, which is adjacent to the first metal layer 134a and the third metal layer 134c, and the electrical conductivity of the conductive region of the active semiconductor layer AP, which is adjacent to the second metal layer 134b, may be higher than the electrical conductivity of the conductive region of the active semiconductor layer AP, which is adjacent to the first metal layer 134a and the third metal layer 134c.

In some example embodiments, the mold structure 130 may include the first metal layer 134a including the first metal and the second metal layer 134b including the second metal, and may not include the third metal layer 134c. In some example embodiments, the mold structure 130 may further include an additional metal layer, in addition to the first to third metal layers 134a, 134b, and 134c.

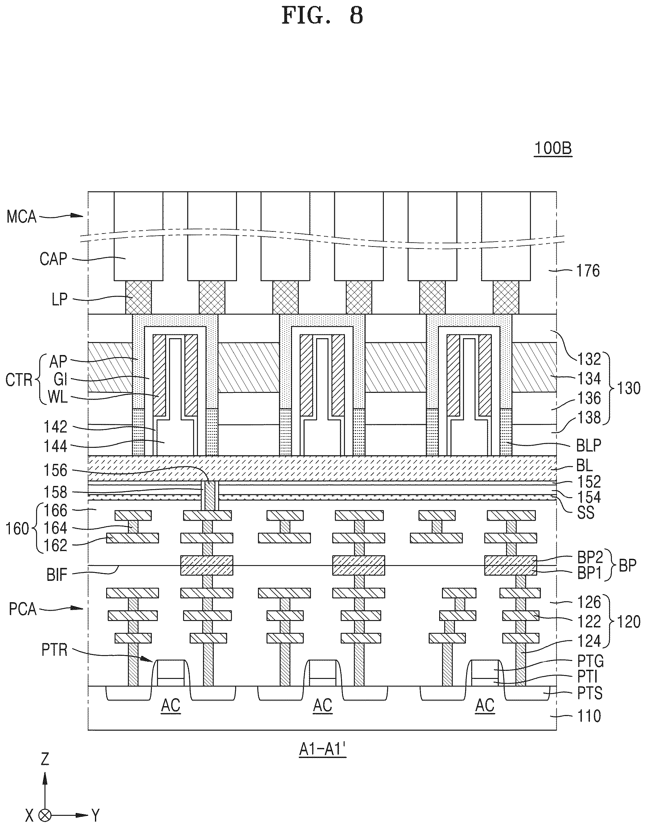

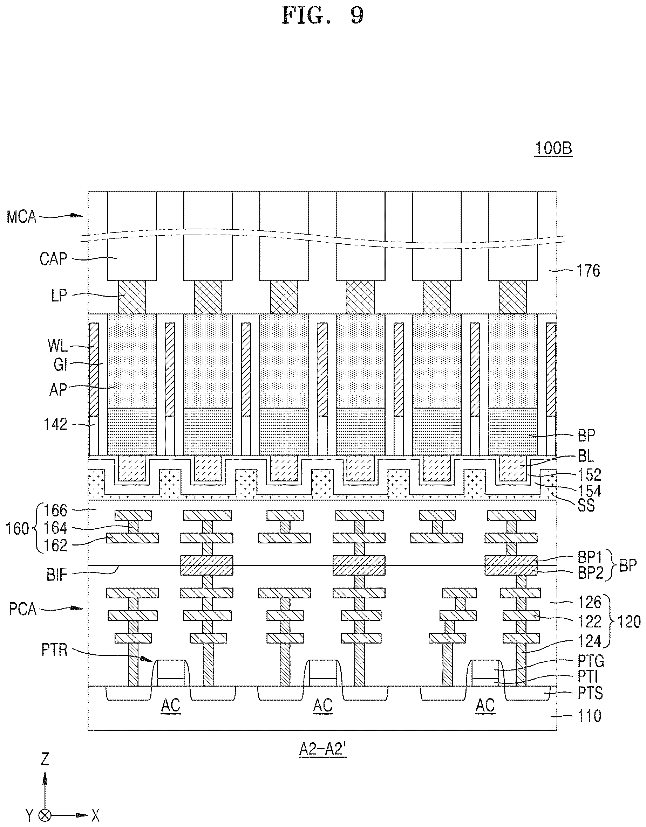

FIGS. 8 and 9 are cross-sectional views showing a semiconductor device 100B according to some example embodiments.

Referring to FIGS. 8 and 9, the peripheral circuit region PCA may be attached to the cell array region MCA using a bonding method. In some example embodiments, a boundary between the peripheral circuit region PCA and the cell array region MCA may be referred to as a bonding interface BIF. For example, a portion of the semiconductor device 100B, which is arranged at a vertical level lower than the bonding interface BIF shown in FIG. 8, may be referred to as the peripheral circuit region PCA, and a portion of the semiconductor device 100B, which is arranged at a vertical level higher than the bonding interface BIF, may be referred to as the cell array region MCA.

In some example embodiments, the peripheral circuit wiring structure 120 and a cell wiring structure 160 may be in contact with each other with the bonding interface BIF therebetween. The cell wiring structure 160 may include a cell wiring layer 162, a cell contact 164, and a cell insulating layer 166.

A bonding pad BP may be arranged at a boundary surface (for example, the bonding interface BIF) between the cell wiring structure 160 and the peripheral circuit wiring structure 120. The bonding pad BP may include a first bonding pad BP1 and a second bonding pad BP2. A top surface of the first bonding pad BP1 may be arranged at the same level as a top surface of the peripheral circuit insulating layer 126. A bottom surface of the second bonding pad BP2 may be arranged at the same level as a bottom surface of the cell insulating layer 166. The top surface of the first bonding pad BP1 may be in contact with the bottom surface of the second bonding pad BP2.

In some example embodiments, the cell wiring structure 160 and the peripheral circuit wiring structure 120 may be in contact with each other by a metal-oxide hybrid bonding method, and in this case, a boundary surface between the peripheral circuit insulating layer 126 and the cell insulating layer 166 may be coplanar with a boundary surface between the first bonding pad BP1 and the second bonding pad BP2 (for example, the boundary surface between the peripheral circuit insulating layer 126 and the cell insulating layer 166 and the boundary surface between the first bonding pad BP1 and the second bonding pad BP2 may be arranged along the bonding interface BIF).

In some example embodiments, the cell wiring structure 160 and the peripheral circuit wiring structure 120 may be attached to each other by an oxide bonding method, and in this case, the bonding pad BP may be omitted.

In some example embodiments, the bit line BL may be arranged closer to the bonding interface BIF than the cell transistor CTR, and the bit line BL may be arranged closer to the bonding interface BIF than the cell capacitor CAP. Accordingly, a vertical distance between the bit line BL and the peripheral circuit transistor PTR may be less than a vertical distance between the cell capacitor CAP and the peripheral circuit transistor PTR.

A portion of the shield metal layer SS may be arranged to occupy space between the plurality of bit lines BL and extend in the second horizontal direction Y. Another portion of the shield metal layer SS may be arranged between bottom surfaces of the plurality of bit lines BL and a top surface of the cell wiring structure 160. A side wall and bottom surface of the bit line BL may be covered by a first bit line insulating layer 152 and a second bit line insulating layer 154, and the first bit line insulating layer 152 and the second bit line insulating layer 154 may be arranged between the side wall of the bit line BL and the shield metal layer SS and between the bottom surface of the bit line BL and the shield metal layer SS.

The mold structure 130 and the cell transistor CTR may be arranged on the bit line BL. The mold structure 130 may include the capping layer 138, the second insulating layer 136, the metal layer 134, and the first insulating layer 132, which are sequentially arranged on the bit line BL.

The active semiconductor layer AP may be arranged on a side wall of the mold structure 130 and may have a rectangular vertical cross-section. The top surface of the active semiconductor layer AP may be coplanar with a top surface of the mold structure 130, and a bit line pad BLP may be arranged between the bottom surface of the active semiconductor layer AP and the bit line BL. A landing pad LP may be arranged on the top surface of the active semiconductor layer AP and the top surface of the mold structure 130.

According to some example embodiments, the cell capacitor CAP may be formed on a carrier substrate, and then, the mold structure 130 and the cell transistor CTR may be formed on the cell capacitor CAP, and the bit line BL, the shield metal layer SS, and the cell wiring structure 160 may be formed on the mold structure 130 and the cell transistor CTR. Next, the peripheral circuit transistor PTR and the peripheral circuit wiring structure 120 may be formed on the substrate 110, and the semiconductor device 100B may be formed by bonding the carrier substrate and the substrate 110 to each other.

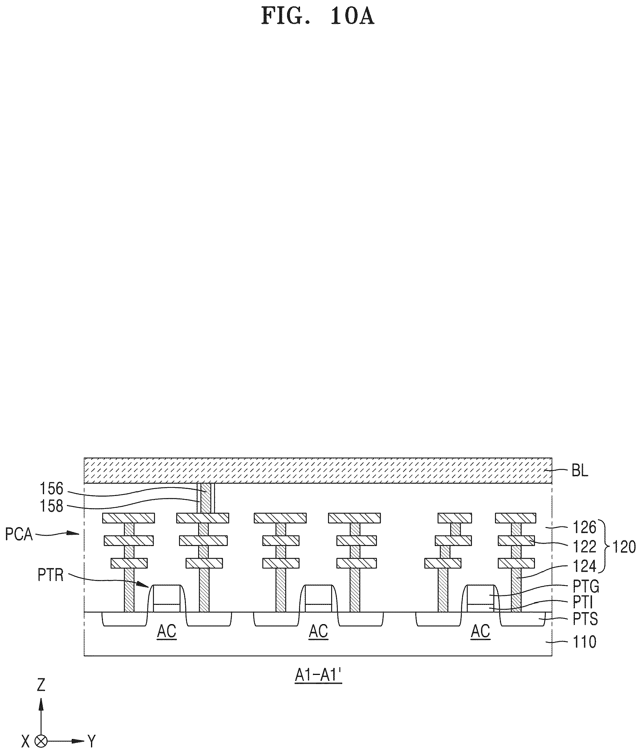

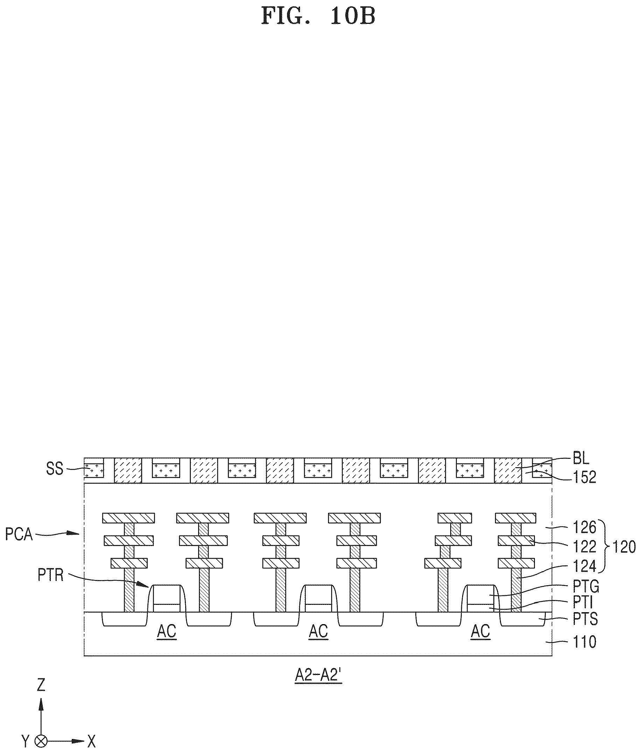

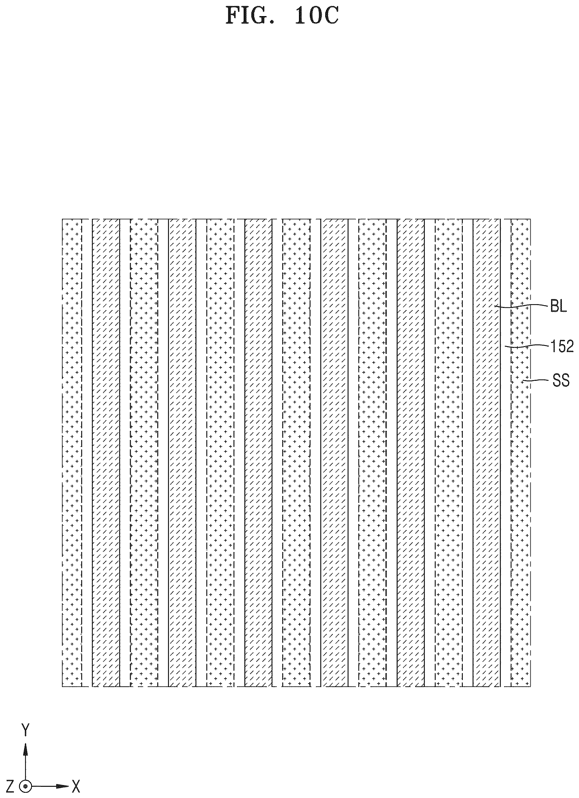

FIGS. 10A, 10B, 10C, 11A, 11B, 11C, 12A, 12B, 13A, 13B, 13C, 14A, 14B, 15A, 15B, 15C, 16A, 16B, 17A, 17B, 18A, 18B, 19A, and 19B are schematic views showing a method of manufacturing the semiconductor device 100 according to some example embodiments. FIGS. 10A, 11A, 12A, 13A, 14A, 15A, 16A, 17A, 18A, and 19A are cross-sectional views taken along the line A1-A1' of FIG. 2, FIGS. 10B, 11B, 12B, 13B, 14B, 15B, 16B, 17B, 18B, and 19B are cross-sectional views taken along the line A2-A2' of FIG. 2, and FIGS. 10C, 11C, 13C, and 15C are plan views corresponding to the cross-sectional views of FIGS. 10A, 11A, 13A, and 15A, respectively.

Referring to FIGS. 10A to 10C, the active region AC may be formed on the substrate 110, and the peripheral circuit transistor PTR may be formed on the active region AC. For example, the peripheral circuit transistor PTR may include the gate electrode PTG, the gate insulating layer PTI, and the source/drain region PTS.

Next, the peripheral circuit wiring 122 and the peripheral circuit contact 124, which are electrically connected to the substrate 110 and the peripheral circuit transistor PTR, may be formed, and the peripheral circuit insulating layer 126 covering the peripheral circuit wiring 122 and the peripheral circuit contact 124 may be formed on the substrate 110. The peripheral circuit insulating layer 126 may be formed using an oxide film, a nitride film, a low-κ dielectric film (i.e., a dielectric film having a dielectric constant less than that of silicon oxide), or a combination thereof.

The bit line BL and the shield metal layer SS may be formed on the peripheral circuit insulating layer 126. In some example embodiments, the bit line BL extending in the second horizontal direction Y may be formed, a first portion of the bit line insulating layer 152 may be conformally formed in space between bit lines BL, and the shield metal layer SS may be formed on the first portion of the bit line insulating layer 152. Next, a second portion of the bit line insulating layer 152 may be formed on a top surface of the shield metal layer SS.

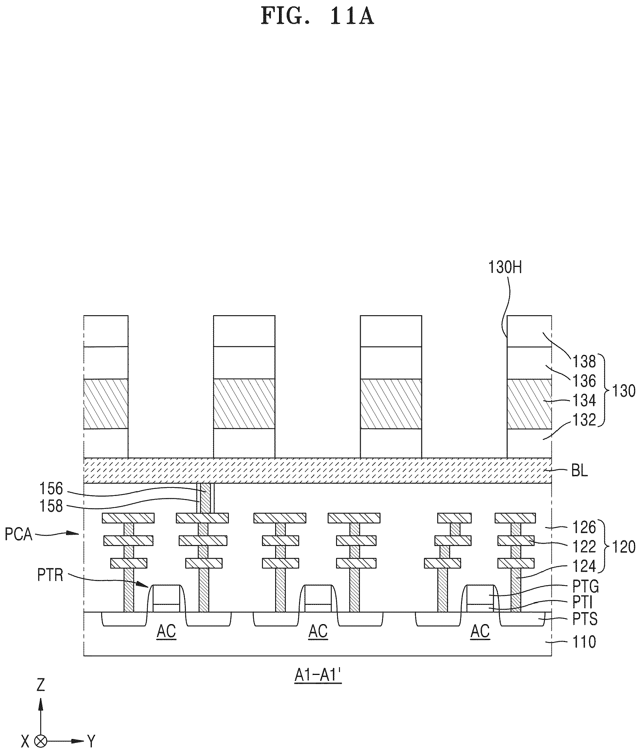

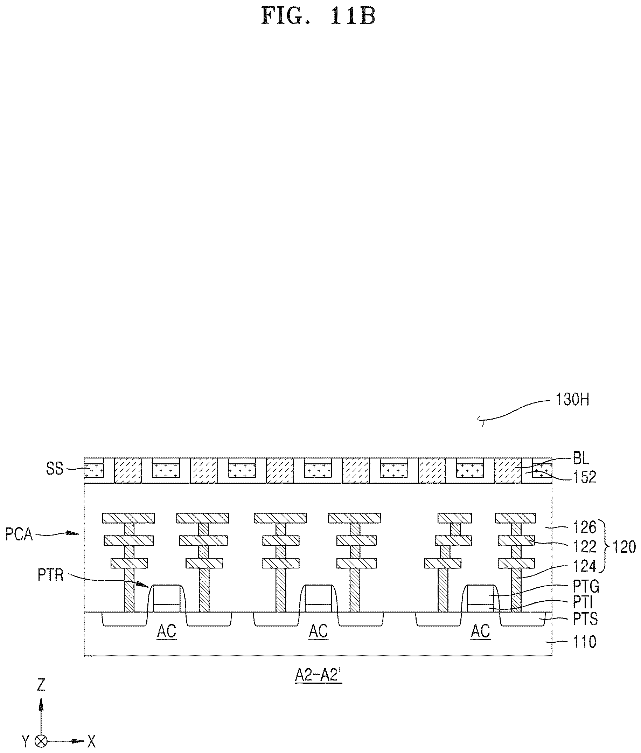

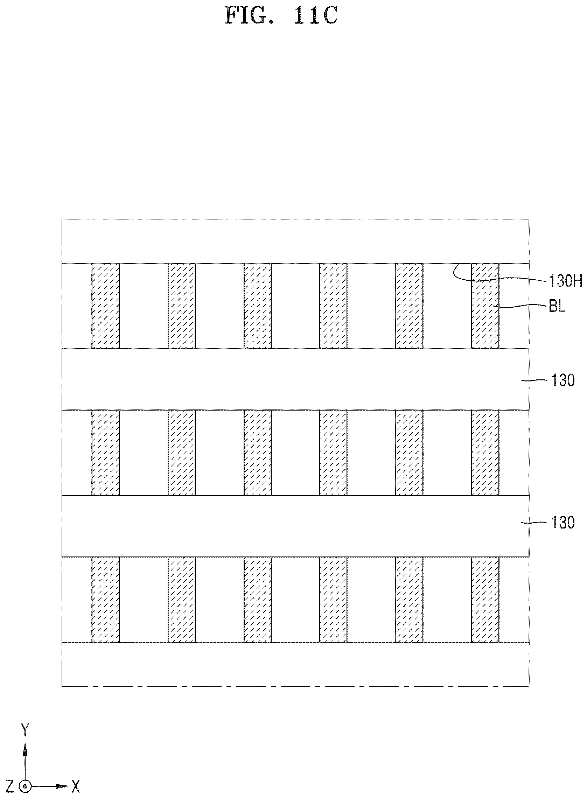

Referring to FIGS. 11A to 11C, a plurality of mold structures 130 extending in the first horizontal direction X may be formed on the bit line BL and a top surface of the bit line insulating layer 152. Each of the plurality of mold structures 130 may include the first insulating layer 132, the metal layer 134, the second insulating layer 136, and the capping layer 138, which are sequentially arranged on the bit line BL and the bit line insulating layer 152.

In some example embodiments, the metal layer 134 may include at least one of aluminum, titanium, tungsten, copper, molybdenum, ruthenium, tantalum, and cobalt. In some example embodiments, the metal layer 134 may further include at least one of titanium nitride, tungsten nitride, molybdenum nitride, ruthenium nitride, tantalum nitride, and cobalt nitride.

In some example embodiments, a cell space 130H extending in the first horizontal direction X may be defined between two adjacent mold structures 130 among the plurality of mold structures 130.

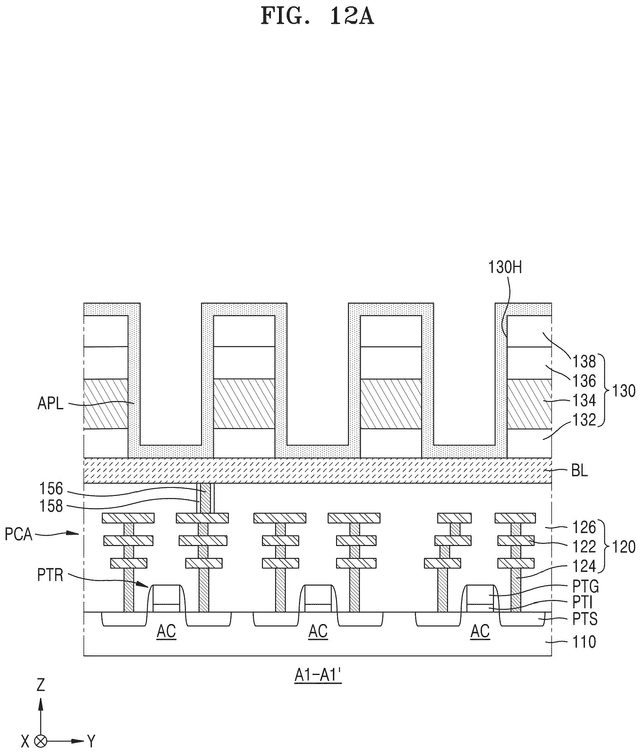

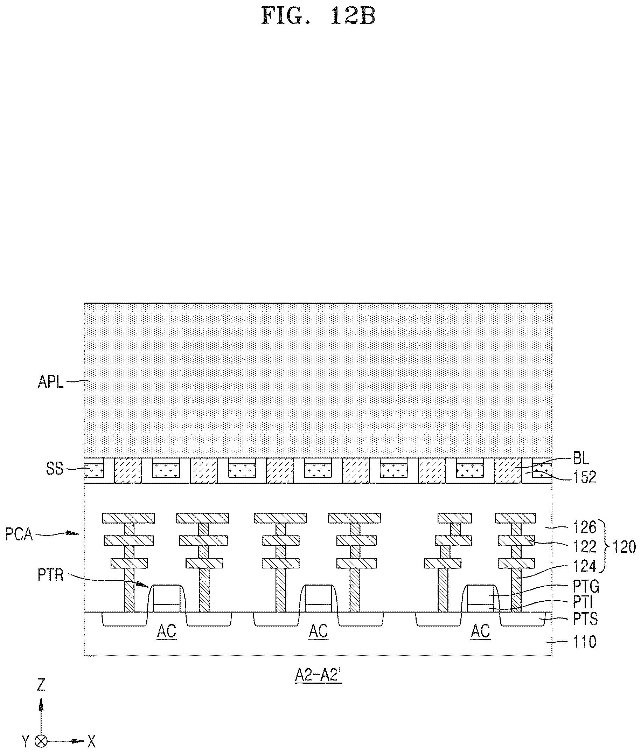

Referring to FIGS. 12A and 12B, a preliminary active semiconductor layer APL may be formed on a side wall of the cell space 130H between the two adjacent mold structures 130. The preliminary active semiconductor layer APL may be conformally arranged on a side wall and top surface of a mold structure 130, a top surface of the bit line BL, and a top surface of the bit line insulating layer 152. For example, the thickness of the preliminary active semiconductor layer APL arranged on the side wall of the mold structure 130 may be equal to or similar to the thickness of the preliminary active semiconductor layer APL arranged on the top surface of the mold structure 130, the top surface of the bit line BL, and the top surface of the bit line insulating layer 152.

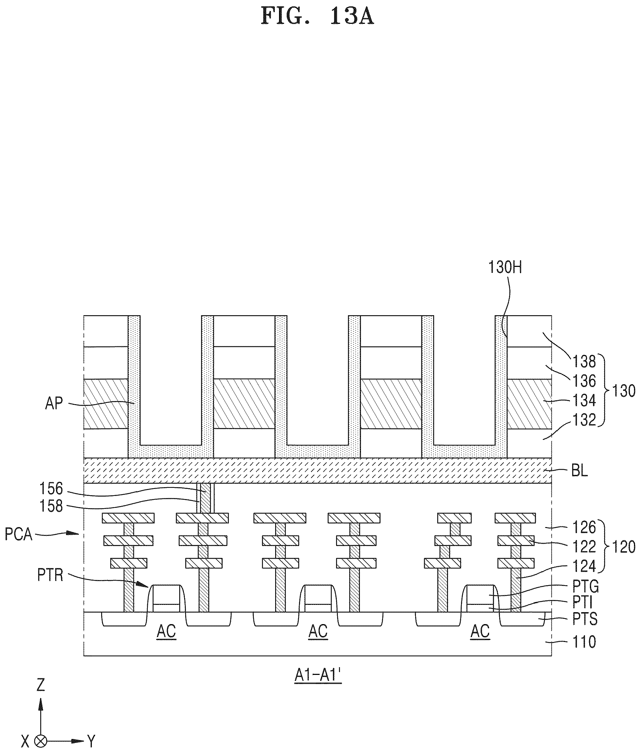

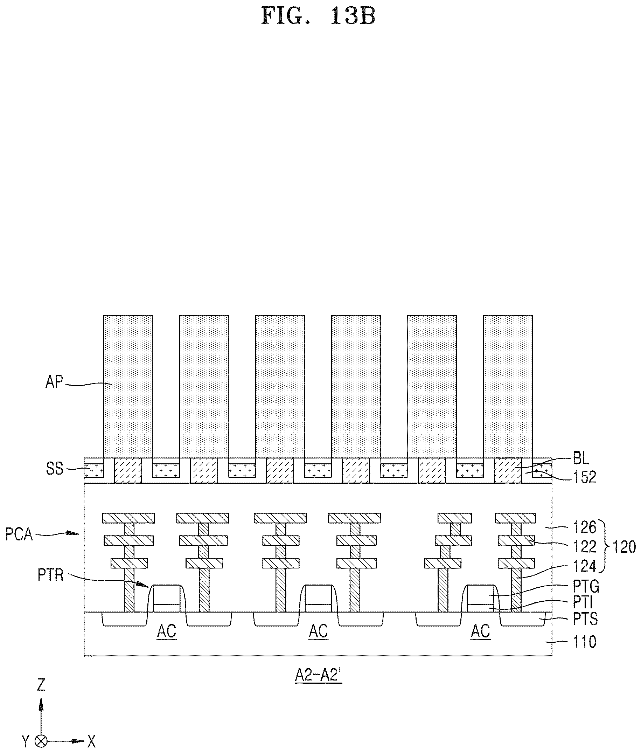

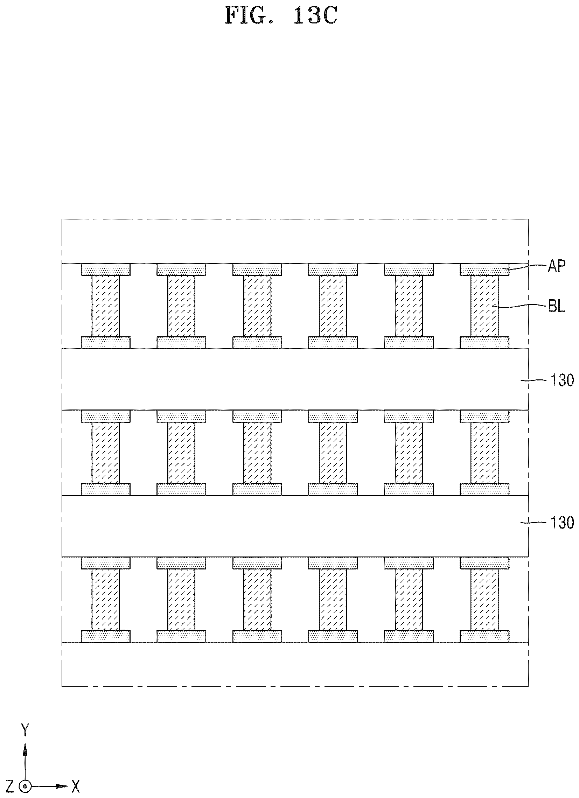

Referring to FIGS. 13A to 13C, the preliminary active semiconductor layer APL may be subjected to an anisotropic etching process or an etch-back process to remove portions of the preliminary active semiconductor layer APL disposed on the top surface of the mold structure 130, and thus, portions of the preliminary active semiconductor layer APL, which are arranged on the side wall of the mold structure 130, the top surface of the bit line BL, and the top surface of the bit line insulating layer 152 may remain.

The top surface (for example, a top surface of the capping layer 138) of the mold structure 130 may be exposed again by the anisotropic etching process or the etch-back process. The top surface (for example, the top surface of the capping layer 138) of the mold structure 130 may be arranged at the same level as a top surface of the preliminary active semiconductor layer APL. In addition, as shown in FIG. 13A, a bottom surface of the preliminary active semiconductor layer APL may be in contact with the top surface of the bit line BL.

Next, a mask pattern extending in the second horizontal direction Y may be formed on the mold structure 130 and the preliminary active semiconductor layer APL, and a portion of the preliminary active semiconductor layer APL, which is not covered by the mask pattern, may be removed. Another portion of the preliminary active semiconductor layer APL, which is covered by the mask pattern, may remain without being remove, and may be referred to as the active semiconductor layer AP.

Active semiconductor layers AP may be arranged apart from each other in the first horizontal direction X between two adjacent mold structures 130, and each of the active semiconductor layers AP may have a U-shaped vertical cross-section.

In some example embodiments, a portion of the active semiconductor layer AP may be in contact with a side wall of the metal layer 134 of the mold structure 130. In a process of forming the active semiconductor layer AP or in a subsequent process, oxygen atoms may move or diffuse into the metal layer 134 in a partial region of the active semiconductor layer AP, which is adjacent to a contact interface between the active semiconductor layer AP and the metal layer 134. Accordingly, the portion of the active semiconductor layer AP, which is in contact with the side wall of the metal layer 134, may have a lower oxygen content than another region of the active semiconductor layer AP (for example, a bulk region of the active semiconductor layer AP), and this region may be referred to as the conductive region AP_i. In addition, a portion of the metal layer 134, which is adjacent to the conductive region AP_i of the active semiconductor layer AP, may have a higher oxygen content than another region of the metal layer 134 (for example, a bulk region of the metal layer 134), and this region may be referred to as the insulating region 134_i.

In some example embodiments, a heat treatment or annealing process for diffusing oxygen atoms included in the active semiconductor layer AP into the metal layer 134 may optionally be further performed after an operation of forming the active semiconductor layer AP or in a subsequent operation.

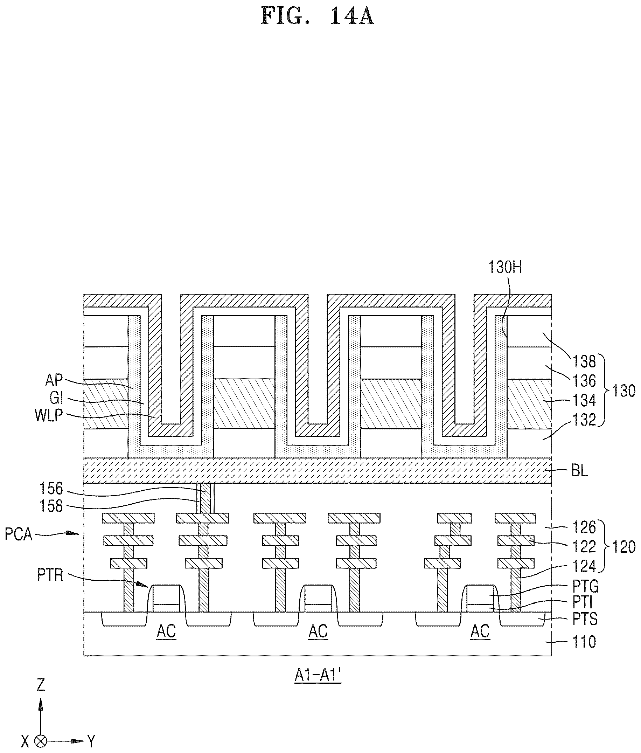

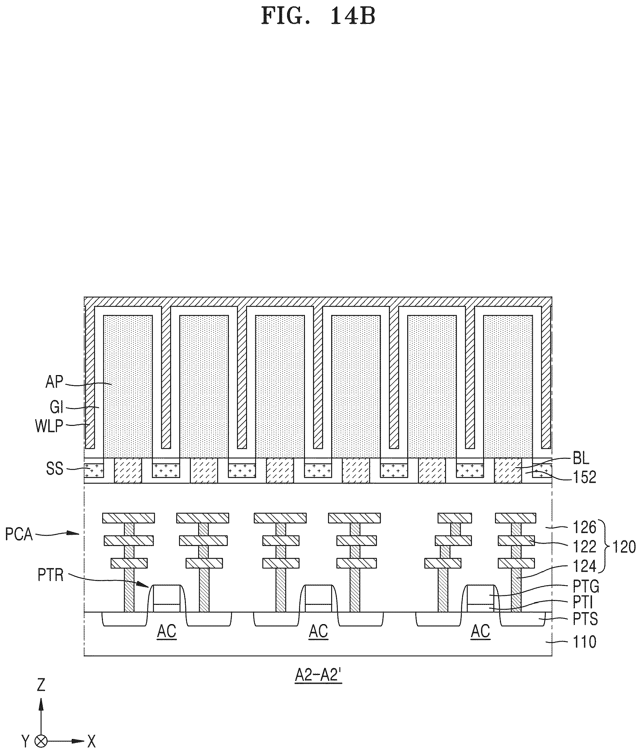

Referring to FIGS. 14A and 14B, the gate insulating layer GI and a word line metal layer WLP may be formed on a side wall of the active semiconductor layer AP.

In some example embodiments, the gate insulating layer GI may be conformally formed on the top surface of the mold structure 130 and the side wall of the active semiconductor layer AP. The word line metal layer WLP may be conformally formed on the gate insulating layer GI, the top surface of the mold structure 130, and the side wall of the active semiconductor layer AP.

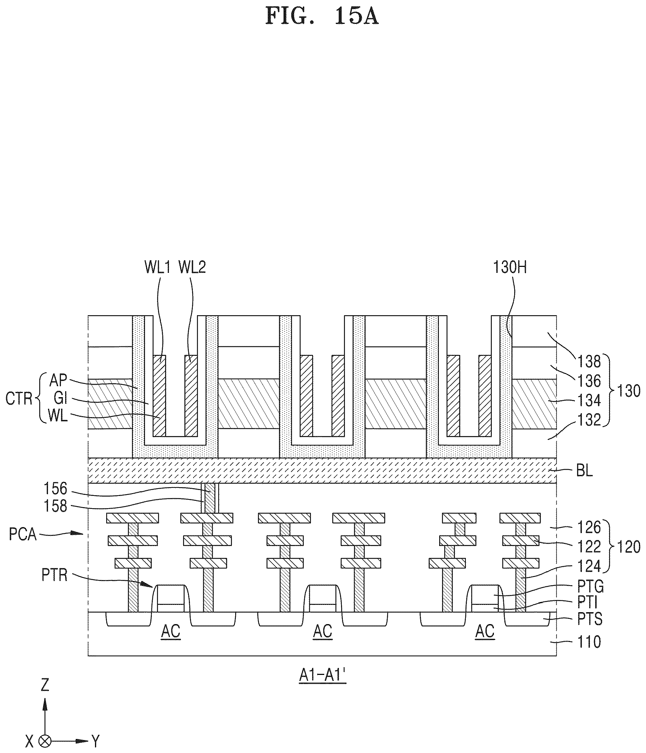

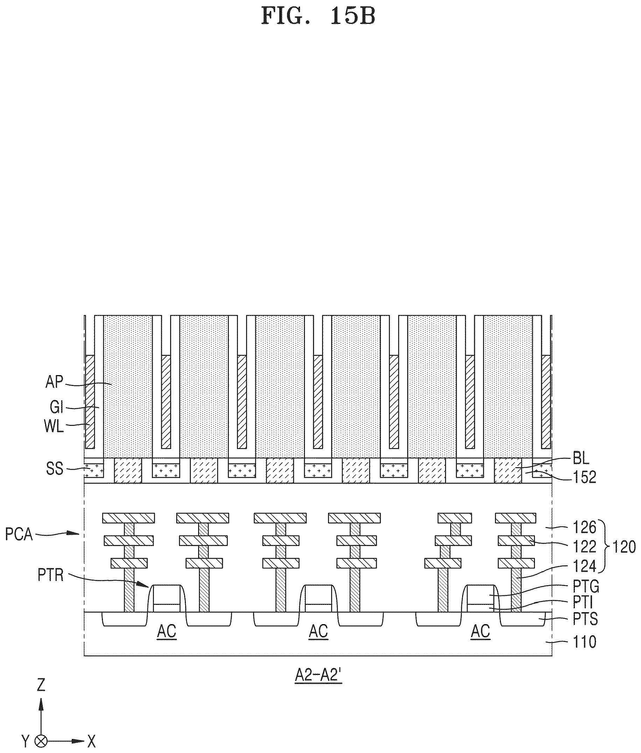

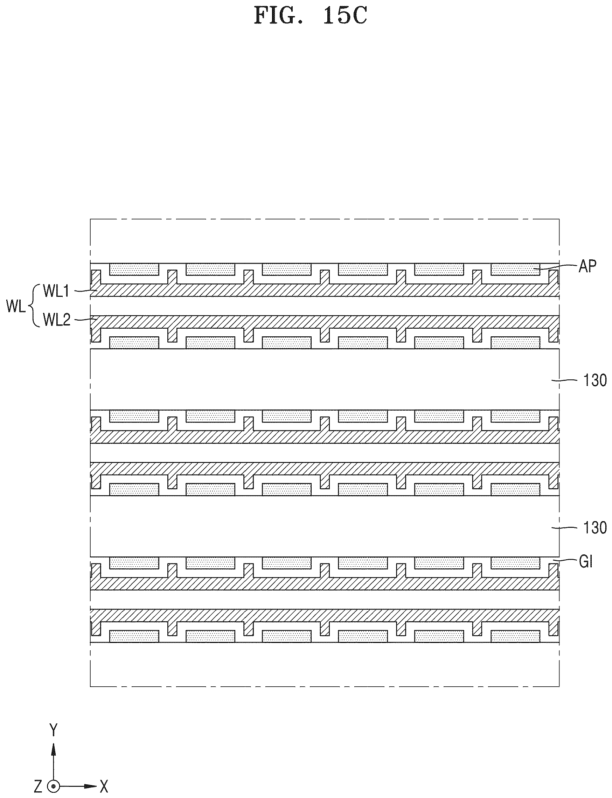

Referring to FIGS. 15A to 15C, the word line WL may be formed by performing an anisotropic etching process or a recess process on an upper side of the word line metal layer WLP.

In the anisotropic etching process or the recess process, the height of the word line WL may be decreased so that the word line WL has a top surface arranged at a lower level than the top surface of the mold structure 130.

As shown in FIG. 15A, between two adjacent mold structures 130, the first word line WL1 may be arranged on a side wall of the mold structure 130 on a left side, and the second word line WL2 may be arranged on a side wall of the mold structure 130 on a right side.

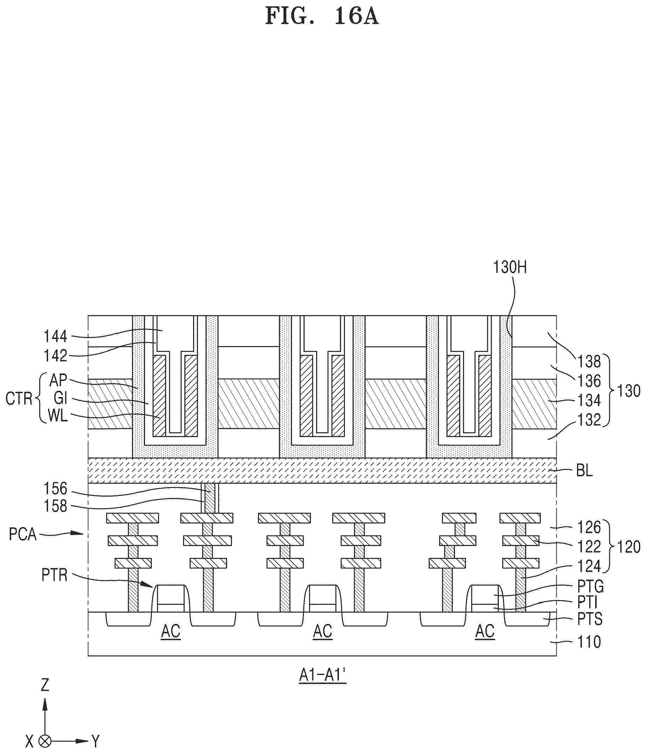

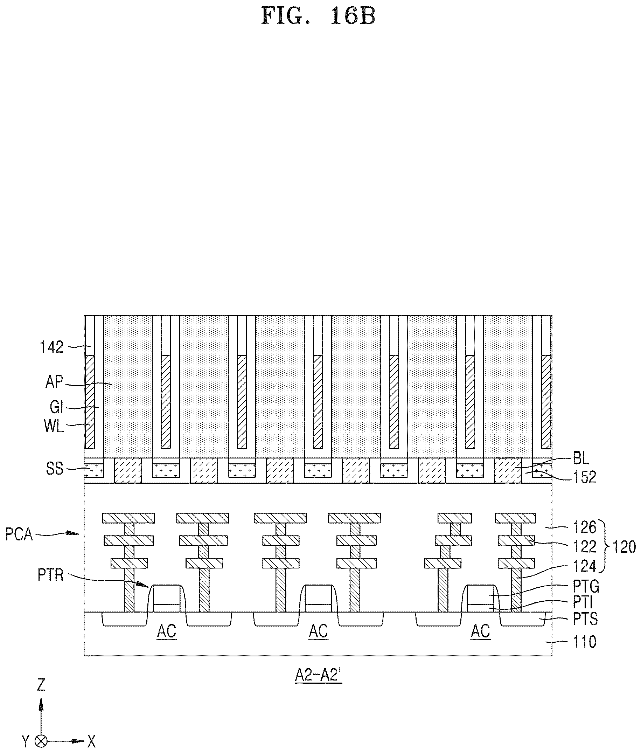

Referring to FIGS. 16A and 16B, the insulating liner 142 and the buried insulating layer 144 may be sequentially formed on the word line WL.

In some example embodiments, the top surface of the mold structure 130 and a top surface of the active semiconductor layer AP may be exposed again by removing a portion of the insulating liner 142, which is arranged on the top surface of the mold structure 130.

A process for removing the portion of the insulating liner 142 may be a grinding or chemical mechanical polishing (CMP) process, and after the grinding or CMP process, a top surface of the buried insulating layer 144, the top surface of the active semiconductor layer AP, and the top surface of the mold structure 130 may be coplanar with each other.

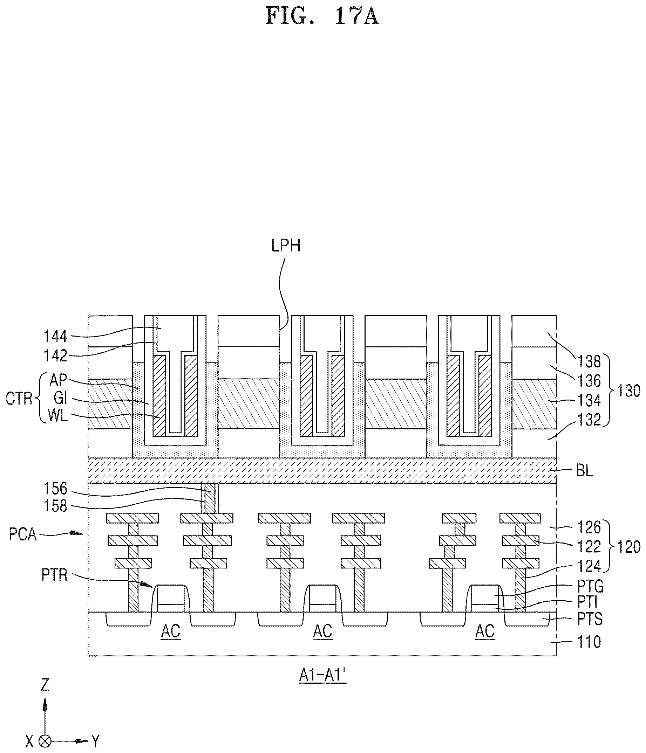

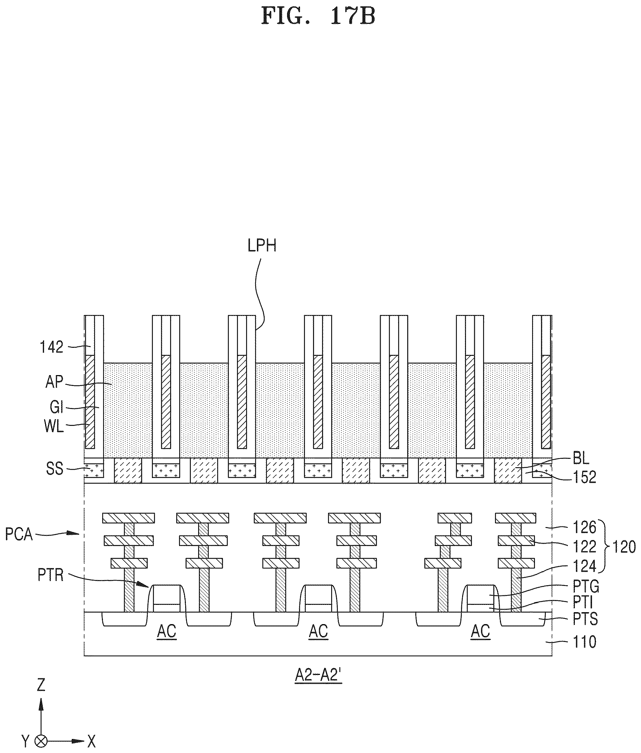

Referring to FIGS. 17A and 17B, a portion of the active semiconductor layer AP may be removed to form a landing pass recess LPH. The top surface of the active semiconductor layer AP may be arranged at a vertical level lower than the top surface of the mold structure 130 by forming the landing pass recess LPH.

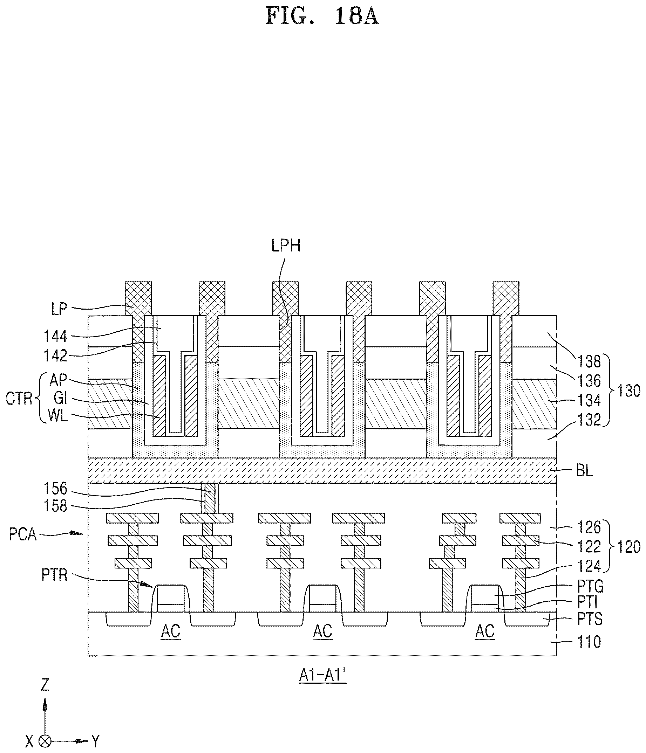

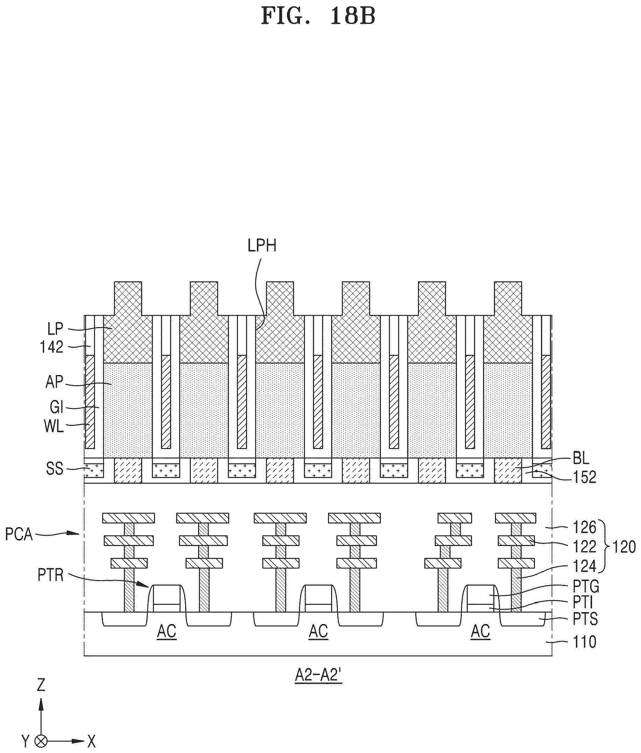

Referring to FIGS. 18A, and 18B, a conductive layer may be formed on the mold structure 130 to occupy the landing pass recess LPH, and the landing pad LP may be formed by patterning an upper side of the conductive layer.

The landing pad LP may include: the lower portion LPb (see FIG. 5) that occupies the landing pass recess LPH; and the upper portion LPu (see FIG. 5) connected to the lower portion LPb and arranged on the top surface of the mold structure 130.

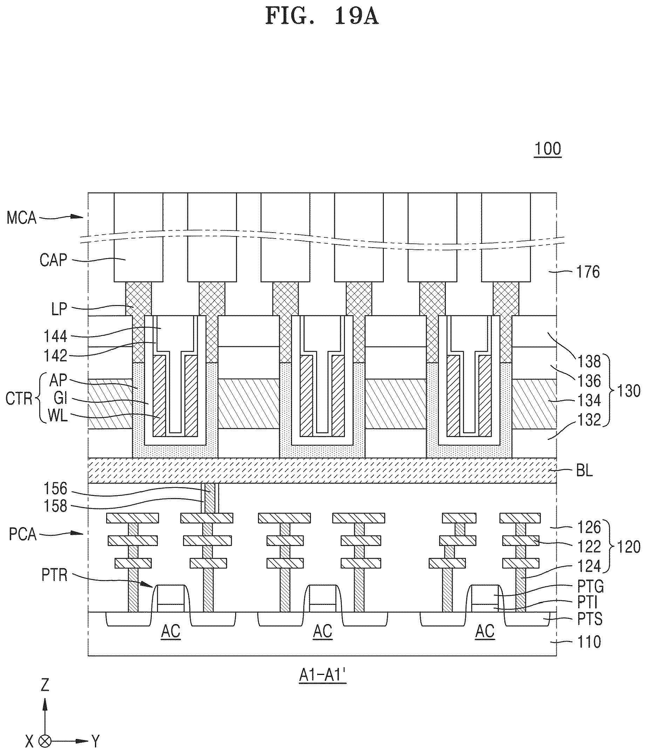

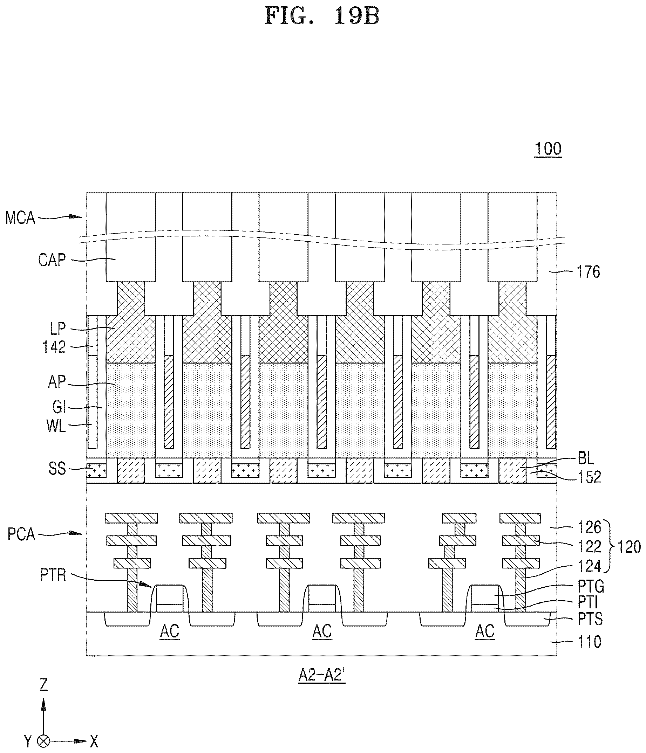

Referring to FIGS. 19A and 19B, the cell capacitor CAP may be formed on the landing pad LP.

The semiconductor device 100 may be completed by performing the aforementioned process.

According to some example embodiments, the mold structure 130 may include the metal layer 134, and the conductive region AP_i may be formed in the portion of the active semiconductor layer AP, which is in contact with the side wall of the metal layer 134. The conductive region AP_i may include a relatively large amount of free electrons, these free electrons may occupy a trap site within the active semiconductor layer AP, and the active semiconductor layer AP may have a reduced trap density compared to the comparative example. Therefore, the semiconductor device 100 may have a relatively high on-current and excellent electrical performance.

According to one or more example embodiments, because an oxygen-deficient conductive region is formed in an active semiconductor layer adjacent to a mold structure including a metal material, the trap density in the active semiconductor layer may be reduced, and on-current of a transistor may increase. Therefore, a semiconductor device may have excellent electrical performance.

While aspects of example embodiments been particularly shown and described, it will be understood that various changes in form and details may be made therein without departing from the scope of the following claims.

## Claims

1. A semiconductor device comprising:
a first bit line (BL) provided on a substrate (110) and extending along a first horizontal direction (Y);
a first mold structure (130) provided on the first bit line (BL), extending along a second horizontal direction (X) crossing the first horizontal direction (Y), and comprising a metal layer (134; 134a, 134b, 134c);
a first active semiconductor layer (AP) extending along a vertical direction (Z) on a side wall of the first mold structure (130) and comprising an oxide semiconductor; and
a word line (WL) provided on a side wall of the first active semiconductor layer (AP) and extending along the second horizontal direction (X),
wherein at least a portion of the side wall of the first active semiconductor layer (AP) is in contact with the metal layer (134; 134a, 134b, 134c).

2. The semiconductor device of claim 1, wherein the first mold structure (130) comprises:
a first insulating layer (132) provided on the first bit line (BL);
the metal layer (134; 134a, 134b, 134c) provided on the first insulating layer (132); and
a second insulating layer (136) provided on the metal layer (134; 134a, 134b, 134c).

3. The semiconductor device of claim 2, wherein the side wall of the first active semiconductor layer (AP) is in contact with each of a side wall of the first insulating layer (132), a side wall of the metal layer (134; 134a, 134b, 134c), and a side wall of the second insulating layer (136).

4. The semiconductor device of any one of claims 1 to 3, wherein a top surface of the metal layer (134; 134a, 134b, 134c) is provided between a top surface of the first active semiconductor layer (AP) and the substrate (110), and
wherein a bottom surface of the first active semiconductor layer (AP) is provided between a bottom surface of the metal layer and the substrate (110).

5. The semiconductor device of any one of claims 1 to 4, wherein a conductive region (AP_i) is provided in a portion of the first active semiconductor layer (AP), which is in contact with the metal layer (134; 134a, 134b, 134c), and
wherein an insulating region (134_i) is provided in a portion of the metal layer (134; 134a, 134b, 134c), which is in contact with the first active semiconductor layer (AP).

6. The semiconductor device of claim 5, wherein an oxygen content in the conductive region (AP_i) is less than an oxygen content in a bulk region of the first active semiconductor layer (AP).

7. The semiconductor device of claim 5 or 6, wherein an oxygen content in the insulating region (134_i) is greater than an oxygen content in a bulk region of the metal layer.

8. The semiconductor device of any one of claims 5 to 7, wherein a bottom surface of the conductive region (AP_i) is spaced apart from a bottom surface of the first active semiconductor layer (AP) along the vertical direction (Z), and
wherein a top surface of the conductive region (AP_i) is spaced apart from a top surface of the first active semiconductor layer (AP) along the vertical direction (Z).

9. The semiconductor device of claim 8, wherein the first active semiconductor layer (AP) comprises at least one of zinc tin oxide, ZnₓSn_{y}O, indium zinc oxide, InₓZn_{y}O, zinc oxide, ZnOₓ, indium gallium zinc oxide, InₓGa_{y}Zn_{z}O, indium gallium silicon oxide, InₓGa_{y}Si_{z}O, indium tungsten oxide, InₓW_{y}O, indium oxide, InₓO, tin oxide, SnₓO, titanium oxide, TiₓO, zinc oxynitride, ZnₓON_{z}, magnesium zinc oxide, MgₓZn_{y}O, zirconium indium zinc oxide, ZrₓIn_{y}Zn_{z}O, hafnium indium zinc oxide, HfₓIn_{y}Zn_{z}O, tin indium zinc oxide, SnₓIn_{y}Zn_{z}O, aluminum tin indium zinc oxide, AlₓSn_{y}In_{z}ZnₐO, silicon indium zinc oxide, SiₓIn_{y}Zn_{z}O, aluminum zinc tin oxide, AlₓZn_{y}Sn_{z}O, gallium zinc tin oxide, GaₓZn_{y}Sn_{z}O, and zirconium zinc tin oxide, ZrₓZn_{y}Sn_{z}O.

10. The semiconductor device of any one of claims 1 to 9, wherein the metal layer (134;
134a, 134b, 134c) comprises at least one of aluminum, titanium, tungsten, copper, molybdenum, ruthenium, tantalum, cobalt, titanium nitride, tungsten nitride, molybdenum nitride, ruthenium nitride, tantalum nitride, and cobalt nitride.

11. The semiconductor device of any one of claims 1 to 10, further comprising:
a peripheral circuit region (PCA) provided on the substrate (110); and
a cell capacitor (CAP) provided on the first active semiconductor layer (AP),
wherein the peripheral circuit region (PCA) is provided between the first bit line (BL) and the substrate (110).

12. The semiconductor device of any one of claims 1 to 10, comprising:
a peripheral circuit region (PCA) provided on the substrate (110);
a plurality of bit lines (BL) provided on the peripheral circuit region (PCA) and extending along the first horizontal direction (Y), the plurality of bit lines (BL) including the first bit line (BL);
a plurality of mold structures (130) provided on the plurality of bit lines (BL), and extending along the second horizontal direction (X) crossing the first horizontal direction (Y), the plurality of mold structures (130) including the first mold structure (130);
a plurality of active semiconductor layers (AP) including the first active semiconductor layer (AP), wherein the first active semiconductor layer (AP) is provided between the first mold structure (130) and a second mold structure (130) among the plurality of mold structures (130), on side walls of the first and second mold structures (130) and on a top surface of each of the plurality of bit lines (BL), and has a U-shaped vertical cross-section;
a second word line (WL) extending along the second horizontal direction (X); and
a plurality of cell capacitors (CAP) provided on the plurality of active semiconductor layers (AP),
wherein at least a portion of each of the plurality of active semiconductor layers (AP) is in contact with the metal layer (134; 134a, 134b, 134c), and
wherein the first word line (WL) and the second word line (WL) are provided between the first and second mold structures (130), and are spaced apart from each other.

13. The semiconductor device of claim 12, wherein a conductive region (AP_i) is provided in a portion of each of the plurality of active semiconductor layers (AP), and is in contact with the metal layer (134; 134a, 134b, 134c), and
wherein an oxygen content in the conductive region (AP_i) is less than an oxygen content in a bulk region of each of the plurality of active semiconductor layers (AP).

14. The semiconductor device of claim 12 or 13, wherein an insulating region (134_i) is provided in a portion of the metal layer (134; 134a, 134b, 134c), and is in contact with each of the plurality of active semiconductor layers (AP), and
wherein an oxygen content in the insulating region (134_i) is greater than an oxygen content in a bulk region of the metal layer (134; 134a, 134b, 134c).
